# EUROPÄISCHE PATENTANMELDUNG

(11) **EP 2 037 498 A1**
(43) Veröffentlichungstag der Anmeldung: **18.03.2009**
(21) Anmeldenummer: 07017801.7
(22) Anmeldetag: 11.09.2007
(51) Int. Cl.: H01L 23/42

(54) **Hochwärmebeständiges Leistungshalbleitermodul**

(71) Anmelder: SIEMENS AKTIENGESELLSCHAFT, 80333 München (DE)
(72) Erfinder: Birner, Martin, 92242 Hirschau (DE); Schierling, Hubert, Dr., 91052 Erlangen (DE)

(57) **Zusammenfassung**

Die Erfindung betrifft ein Leistungshalbleitermodul mit einem plattenförmigen Schaltungsträger (1) und einem Gehäuse (2) bzw. ein Verfahren zur Herstellung eines solchen Leistungshalbleitermoduls. Der Schaltungsträger (1) wird in das Gehäuse (2) als Gehäusewand, insbesondere Gehäuseboden, eingesetzt, wobei mindestens ein Halbleiterbauelement (5) auf der Innenseite des Schaltungsträgers elektrisch leitend angeordnet wird. Zur Abfuhr einer im Gehäuse (2) entstehenden Wärme wird das Gehäuse (2) durch einen pulverförmigen, wärmeleitfähigen Werkstoff (3) gefüllt. Im Vergleich zu einem normalen Füllungsmaterial bietet der pulverförmige, wärmeleitfähige Werkstoff eine deutliche verbesserte Wärmeleitfähigkeit für das Leistungshalbleitermodul.

## Beschreibung

Die Erfindung betrifft ein Leistungshalbleitermodul mit einem plattenförmigen Schaltungsträger und einem Gehäuse bzw. ein Verfahren zur Herstellung eines solchen Leistungshalbleitermoduls.

Mit zunehmender Erhöhung der Leistungsdichte in Halbleiterschaltelementen, die jeweils ein Gehäuse und mehrere Halbleiterchips in diesem Gehäuse umfassen, stellt die im Gehäuse entstehende Wärme immer mehr ein Problem dar. Eine zu hohe Temperatur im Gehäuse eines Halbleiterschaltelements beeinträchtigt die Lebensdauer bzw. die Arbeitscharakteristik des Halbleiterschaltelements.

Heutzutage wird ein Leistungshalbleitermodul so ausgebildet, dass es einen plattenförmigen Schaltungsträger, der ein DCB-Substrat (DCB: Direct Copper Bonding) sein kann, und ein Gehäuse aufweist, wobei der Schaltungsträger in das Gehäuse als Gehäusewand, insbesondere Gehäuseboden, eingesetzt wird. Auf einer Seite des Schaltungsträgers, der innerhalb des Gehäuses liegt, wird mindestens ein Halbleiterbauelement (z.B. Halbleiterchip) elektrisch leitend angeordnet. Ein Kühlelement (z.B. Kühlkörper) ist zur Wärmeabfuhr außerhalb des Gehäuses mit dem Schaltungsträger verbunden. Wärme, die durch Verlustleistung von Halbleiterchips generiert ist, kann dann über eine Verbindungsschicht an die Umgebung des Leistungshalbleitermoduls abgeführt werden, wobei die Verbindungsschicht aus den Halbleiterchips, dem Schaltungsträger und dem Kühlkörper besteht. Um das Leistungshalbleitermodul optimal zu kühlen, ist es notwendig, die im Gehäuse entstehende Wärme neben der kühlkörperseitigen Entwärmung auch zusätzlich von der Oberseite der Halbleiterchips und des Schaltungsträgers abzuführen.

Nach derzeitigem Stand der Technik wird ein Gehäuse eines Leistungshalbleitermoduls in der Regel mit Gießharzen oder Moldmassen (z.B. Silikon-Moldmassen) vergossen. Wird Giesharz als Füllungsmaterial verwendet, kann es nach seiner Aushärtung nicht mehr nachgeben, und es kann im Gehäuse eines Leistungshalbleitermoduls eine starke thermomechanische Spannung ausgelöst werden. Die im Gehäuse angeordneten Bauelemente (Halbleiterchips) bzw. ihre elektrischen Verbindungen können beeinträchtigt werden. Silikon-Moldmassen sind vergleichsweise weich, haben jedoch eine schlechte Wärmeleitfähigkeit.

Der Erfindung liegt die Aufgabe zugrunde, die Eigenschaft, insbesondere die Wärmeleitfähigkeit, eines Leistungshalbleitermoduls zu verbessern.

Diese Aufgabe wird erfindungsgemäß durch ein Leistungshalbleitermodul mit den Merkmalen des Patentanspruchs 1 und ein Verfahren mit den Merkmalen des Patentanspruchs 6 gelöst. Die abhängigen Ansprüche betreffen vorteilhafte Weiterbildungen und Ausgestaltungen der Erfindung.

Der Erfindung liegt die Erkenntnis zugrunde, die in einem Gehäuse entstehende Wärme möglichst gleichmäßig zu verteilen und nach außen abzuführen. Während des Betriebes des Leistungshalbleitermoduls kann eine Wärme mit einer hohen Temperatur im Gehäuse des Leistungshalbleitermoduls bspw. wegen Leistungsverlust ausgelöst werden. Zur Verbesserung der Eigenschaft, insbesondere die Wärmeleitfähigkeit, des Leistungsmoduls wird das Gehäuse durch einen pulverförmigen, wärmeleitfähigen Werkstoff, z.B. keramisches Pulver, gefüllt. Im Vergleich zu heute eingesetzten Gießharzen oder Molmassen als ein Füllungsmaterial bieten pulverförmige Werkstoffe eine deutlich verbesserte Wärmeleitfähigkeit. Zudem wird ein Schwund vom Füllungsmaterial im Gehäuse vermieden, da die pulverförmigen Werkstoffe nicht ausgehärtet werden. Somit treten keine mechanischen Spannungen auf. Durch die Wahl eines pulverförmigen Werkstoffes als Füllungsmaterial werden die entstehenden thermomechanischen Spannungen zwischen dem Füllungsmaterial und dem Halbleiterbauelement bzw. dem Gehäuse deutlich minimiert. Darüber hinaus, sind verschiedene heute bekannte Verbindungsverfahren, wie z.B. Wirebonding, Verbindungsbügel oder planare Verbindungen unter Verwendung von pulverförmigen Werkstoffen bei einem Leistungshalbleitermodul möglich. Dadurch kann auch ein mechanischer Schutz bzw. Fixierung für solche Verbindungen im Gehäuse eines Leistungshalbleitermoduls realisiert werden.

Gemäß einer vorteilhaften Ausgestaltung der Erfindung wird das Gehäuse des Leistungshalbleitermoduls mit dem pulverförmigen, wärmeleitfähigen Werkstoff und einer wärmeleitfähigen Flüssigkeit gefüllt. Dabei wird die Wärmeleitfähigkeit des Leistungshalbleitermoduls durch die Tränkung des pulverförmigen Werkstoffs mit der wärmeleitfähigen Flüssigkeit (z.B. Glycerol und Glycole) erhöht, denn die Wärme wird durch die Mischung des pulverförmigen Werkstoffs und der wärmeleitfähigen Flüssigkeit gleichmäßiger verteilt.

Gemäß einer anderen vorteilhaften Ausgestaltung der Erfindung wird das Gehäuse mit dem pulverförmigen, wärmeleitfähigen Werkstoff und einer inerten, isolierenden Flüssigkeit (z.B. Fluorinert oder Perfluoropolyether) gefüllt. Dadurch kann eine Isolationsfähigkeit im Gehäuse des Leistungshalbleitermoduls verbessert werden. Ein elektrischer Überschlag zwischen potential führenden Teilen des Leistungshalbleitermoduls wird somit besser verhindert. Die Teilentladungsfestigkeit oder die Isolationsspannung des Leistungshalbleitermoduls kann auch erhöht werden.

Vorteilhafterweise wird das Gehäuse des Leistungshalbleitermoduls mit dem pulverförmigen, wärmeleitfähigen Werkstoff voll gefüllt und mit einer geeigneten Deckschicht (z.B. Gehäusedeckel oder Deckverguss) ausgeführt.. Dadurch können mechanische Verbindungen der im Gehäuse eingebauten Bauelemente stabil gehalten und somit ein zusätzlicher Schutz oder eine Fixierung für nach außen geführte Verbindungselemente geboten werden.

Gemäß einer anderen vorteilhaften Ausgestaltung der Erfindung weist das Leitungshalbleitermodul mindestens einen außerhalb des Gehäuses geführten Kontaktstift auf, wobei der Kontaktstift im Gehäuse mit dem Schaltungsträger verbunden werden kann. Ein Kontaktstift kann bspw. ein Lötstift, Schweißstift, Einpressstift oder ein federnder Kontaktstift in Form von z.B. Spiralfedern oder Blattfedern sein. Die Funktionsfähigkeit solcher Verbindungselemente bleibt somit voll erhalten.

Weiterhin wird ein Verfahren zur Herstellung eines Leistungshalbleitermoduls mit einem plattenförmigen Schaltungsträger und einem Gehäuse angegeben, wobei der Schaltungsträger in das Gehäuse als Gehäusewand, insbesondere Gehäuseboden, eingesetzt wird. Mindestens ein Halbleiterbauelement wird auf einer innerhalb des Gehäuses liegenden Seite des Schaltungsträgers elektrisch leitend angeordnet. Zur Abfuhr der Wärme, die wegen Leistungsverlust während des Betriebes des Leistungshalbleitermoduls im Gehäuse entsteht, wird das Gehäuse durch einen pulverförmigen, wärmeleitfähigen Werkstoff, z.B. keramisches Pulver, gefüllt. Dadurch kann die im Gehäuse entstehende Wärme nach außen an die Umgebung des Leistungshalbleitermoduls abgeführt werden.

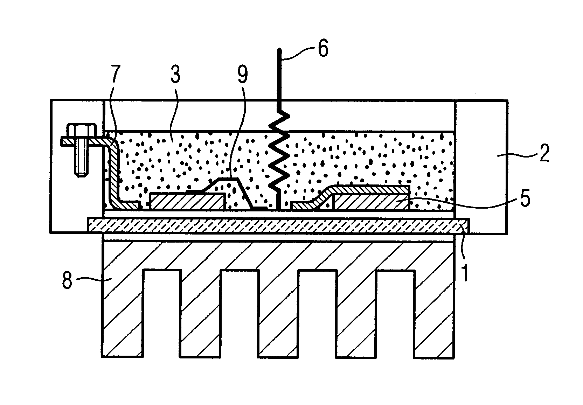

Nachfolgend wird die Erfindung anhand des in der Figur dargestellten Ausführungsbeispiels näher beschrieben und erläutert. Es zeigen:
- FIG: ein Beispiel eines erfindungsgemäßen Leistungshalb- leitermoduls.

In der FIG wird ein Leistungshalbleitermodul angezeigt. Dieses Leistungshalbleitermodul weist einen Schaltungsträger 1 und ein Gehäuse 2 auf, wobei der Schaltungsträger 1 eine Keramikplatte ist und als Gehäuseboden in das Gehäuse 2 eingesetzt wird. Das Gehäuse 2 ist mit einem Kühlkörper 8 zur Wärmeabfuhr mechanisch verbunden. Auf der Innenseite des Schaltungsträgers 1 werden mehrere Halbleiterbauelemente 5 (z.B. Halbleiterchips) elektrisch leitend angeordnet. Dabei wird mindestens ein außerhalb des Gehäuses 2 führender Lastanschluss 7 in das Gehäuse 2 eingebaut, wobei der Lastanschluss 7 zur elektrischen Verbindung des Leistungshalbleitermoduls mit anderen elektrischen Geräten vorgesehen ist. Das Gehäuse 2 wird mit wärmeleitfähigen, keramischen Pulvern 3 gefüllt. Die in das Gehäuse 2 eingebrachten, keramischen Pulver 3 werden mittels einer geeigneten Deckschicht des Gehäuses 2 fixiert. Die keramischen Pulver 3 bieten im Vergleich zu heute eingesetzten Gießharzen oder Moldmassen eine deutliche verbesserte Wärmeleitfähigkeit. Dadurch, dass das Gehäuse 2 mit den keramischen Pulvern 3 voll gefüllt wird, kann die Wärme, die wegen Leistungsverlust während des Betriebs des Leistungshalbleitermoduls im Gehäuse 2 geniert ist, nicht nur über eine Verbindungsschicht, die aus den Halbleiterbauelementen 5, dem Schaltungsträger 1 und dem Kühlkörper 8 ausgebildet wird, sondern auch von der Oberseite der Halbleiterbauelemente 5 und des Schaltungsträgers 1 effektiv an die Umgebung des Leistungshalbleitermoduls abgeführt. Insbesondere wenn in die Deckschicht eine weiteres Kühlelement eingebaut wird. Die keramischen Pulver 3 können auch mit einer wärmeleitfähigen Flüssigkeit (z.B. Glycerol od. Glycole) oder einer inerten, isolierenden Flüssigkeit (z.B. Fluorinert oder Perfluoropolyether) getränkt werden, um die Wärmeleitfähigkeit zu erhöhen oder eine Isolationsfähigkeit zu verbessern.

Mindestens ein außerhalb des Gehäuses 2 führender Kontaktstift 6 kann in das Gehäuse 2 eingebaut und mit dem Schaltungsträger 1 verbunden werden. Ein derartiger Kontaktstift 6 ist in der Regel ein Lötstift, Schweißstift, Einpressstift oder ein federnder Kontaktstift in Form von z.B. Spiralfedern oder Blattfedern und zur Erweiterung der Anschlussmöglichkeit des Leistungshalbleitermoduls zu verwenden. Durch die Einbettung des Kontaktstiftes 6 in einen pulverförmigen Werkstoff wird im Gegensatz zu harten Vergussmassen die Funktionsfähigkeit z.B. federnder Kontakte voll erhalten.

Die keramischen Pulver 3 können Anwendung bei unterschiedlichen Arten von Verbindungen 9 der Halbleiterbauelemente 5, wie z.B. Wirebonding, Verbindungsbügeln oder planaren Verbindungen finden. Durch die gefüllten keramischen Pulver 3 wird eine thermomechanische Spannung zwischen dem Füllungsmaterial (den keramischen Pulvern 3) und dem Gehäuse 2 oder den Bauelementen 5 deutlich minimiert. Darüber hinaus, werden die keramischen Pulver 3 nicht ausgehärtet. Ein Schwund vom Füllungsmaterial kann bei seinem Aushärten vermieden werden. Daher treten keine mechanischen Spannungen hierbei auf. Dadurch, dass die keramischen Pulver 3 als Füllungsmittel in das Gehäuse 2 eingebracht bzw. das Gehäuse 2 voll gefüllt werden, können die Verbindungen 9 der Halbleiterbauelementen 5, des Lastanschlusses 7 bzw. des Kontaktstiftes 6 stabil gehalten und damit gegen eine mechanische Kraft geschützt werden.

Ein in dieser FIG angezeigtes Leistungshalbleitermodul weist gegenüber bisher bekannten Leistungshalbleitermodulen eine bessere Eigenschaft, insbesondere eine bessere Wärmeleitfähigkeit, auf. Im Betrieb des Leistungshalbleitermoduls kann die Temperatur der Halbleiterbauelemente 5 schneller gesenkt werden. Somit kann die Stromtragfähigkeit des Leistungshalbleitermoduls auch erhöht werden.

## Patentansprüche

1. Leistungshalbleitermodul mit einem plattenförmigen Schaltungsträger (1) und einem Gehäuse (2),
wobei der Schaltungsträger (1) im Gehäuse (2) als Gehäusewand, insbesondere Gehäuseboden, eingesetzt ist, und wobei mindestens ein Halbleiterbauelement (5) innerhalb des Gehäuses (2) auf dem Schaltungsträger (1) elektrisch leitend angeordnet ist
**dadurch gekennzeichnet, dass** das Gehäuse (2) durch einen pulverförmigen, wärmeleitfähigen Werkstoff (3) zur Abführung der im Gehäuse (2) entstehender Wärme gefüllt ist.

2. Leistungshalbleitermodul nach Anspruch 1, wobei das Gehäuse (2) mit dem pulverförmigen, wärmeleitfähigen Werkstoff (3) und einer wärmeleitfähigen Flüssigkeit gefüllt ist.

3. Leistungshalbleitermodul nach Anspruch 1 oder 2, wobei das Gehäuse (2) mit dem pulverförmigen, wärmeleitfähigen Werkstoff (3) und einer inerten, isolierenden Flüssigkeit gefüllt ist.

4. Leistungshalbleitermodul nach einem der vorstehenden Ansprüche, wobei
das Gehäuse (2) mit dem pulverförmigen, wärmeleitfähigen Werkstoff (3) voll gefüllt ist.

5. Leistungshalbleitermodul nach einem der vorstehenden Ansprüche, wobei
das Leitungshalbleitermodul mindestens einen außerhalb des Gehäuses (2) geführten Kontaktstift (6) aufweist, wobei der Kontaktstift (6) in dem Gehäuse (2) mit dem Schaltungsträger (1) verbunden ist.

6. Verfahren zur Herstellung eines Leistungshalbleitermoduls mit einem plattenförmigen Schaltungsträger (1) und einem Gehäuse (2),
wobei der Schaltungsträger (1) in das Gehäuse (2) als eine Gehäusewand, insbesondere Gehäuseboden, eingesetzt wird, und wobei mindestens ein Halbleiterbauelement (5) innerhalb des Gehäuses (2) auf den Schaltungsträger (1) elektrisch leitend angeordnet wird,
**dadurch gekennzeichnet, dass**
das Gehäuse (2) durch einen pulverförmigen, wärmeleitfähigen Werkstoff (3) gefüllt wird, um eine im Betrieb des Leistungshalbleitermoduls im Gehäuse (2) erzeugte Wärme nach außen abzuführen.

7. Verfahren nach Anspruch 6, wobei
das Gehäuse (2) mit dem pulverförmigen, wärmeleitfähigen Werkstoff (3) und einer wärmeleitfähigen Flüssigkeit gefüllt wird.

8. Verfahren nach Anspruch 6 oder 7, wobei
das Gehäuse (2) mit dem pulverförmigen, wärmeleitfähigen Werkstoff (3) und einer inerten, isolierenden Flüssigkeit gefüllt wird.

9. Verfahren nach einem der Ansprüche 6 bis 8, wobei das Gehäuse (2) mit dem pulverförmigen, wärmeleitfähigen Werkstoff (3) voll gefüllt wird.

10. Verfahren nach einem der Ansprüche 6 bis 9, wobei mindestens ein außerhalb des Gehäuses (2) geführter Kontaktstift im Gehäuse (2) mit dem Schaltungsträger (1) verbunden wird.
